(19) Europäisches Patentamt
European Patent Office
Office européen des brevets

(11) EP 1 780 778 A1

(12) **EUROPEAN PATENT APPLICATION**
published in accordance with Art. 158(3) EPC

(43) Date of publication:
02.05.2007 Bulletin 2007/18

(51) Int Cl.:
$H01L\ 21/308$ (2006.01)  $H01L\ 21/304$ (2006.01)

(21) Application number: 05757755.3

(86) International application number:
PCT/JP2005/012784

(22) Date of filing: 11.07.2005

(87) International publication number:
WO 2006/009003 (26.01.2006 Gazette 2006/04)

(84) Designated Contracting States:
AT BE BG CH CY CZ DE DK EE ES FI FR GB GR HU IE IS IT LI LT LU LV MC NL PL PT RO SE SI SK TR

(30) Priority: 16.07.2004 JP 2004210807

(71) Applicants:
• TOHOKU UNIVERSITY
Aoba-ku
Sendai-shi, Miyagi 980-8577 (JP)
• Stella Chemifa Corporation
Osaka-shi, Osaka 541-0047 (JP)

(72) Inventors:
• OHMI, Tadahiro
Sendai-shi,
Miyagi 980-0813 (JP)

• TERAMOTO, Akinobu
Sendai-shi,
Miyagi 983-0037 (JP)
• KIKUYAMA, Hirohisa
5950075 (JP)
• NII, Keiichi
5950075 (JP)
• YAMAMOTO, Masashi
Sendai-shi,
Miyagi 984-0073 (JP)

(74) Representative: Glawe, Delfs, Moll
Patentanwälte
Postfach 26 01 62
80058 München (DE)

(54) **PROCESS LIQUID FOR SEMICONDUCTOR DEVICE, PROCESSING METHOD, AND APPARATUS FOR MANUFACTURING SEMICONDUCTOR**

(57) Disclosed is a process liquid which causes only little dissolution of atoms from a semiconductor surface and enables to form a clean and flat semiconductor surface. Also disclosed are a processing method and an apparatus for manufacturing a semiconductor. Specifically disclosed is a process liquid which causes only little dissolution of atoms from a semiconductor surface by using an aqueous solution containing at least one alcohol or ketone, thereby realizing a clean and flat surface.

[FIG. 8]

EP 1 780 778 A1

**Description**

Technical Field

This invention relates to a processing liquid and a processing method for a semiconductor device, and a semiconductor manufacturing apparatus and, in particular, relates to a processing liquid and a processing method for a semiconductor device, that can form a clean and flat semiconductor surface, and a semiconductor manufacturing apparatus that can form a clean and flat semiconductor surface.

Background Art

It has been pointed out that the surface roughness of semiconductor surfaces or semiconductor oxide film/semiconductor interfaces causes deterioration in properties of electronic elements such as MOS devices. While the influence of the surface roughness to the device properties has not been actualized in the manufacture of devices having relatively large sizes, it is becoming unignorable due to a reduction in thickness of MOSFET gate oxide films and so on following the miniaturization of devices in recent years.

The RCA cleaning including nearly 20 processes has conventionally been known as a method of processing semiconductor surfaces and particularly no problem arose when it was developed 30 years ago. However, since the surface roughness of a semiconductor increases according to this cleaning method, a problem has arisen in the manufacture of current semiconductor integrated circuit devices in which it is necessary to form a silicon oxide film having a thickness of 100Å or less.

Further, as a semiconductor cleaning method, a semiconductor surface treatment is carried out using an aqueous solution or a nonaqueous solution containing a cleaning composition comprised of acid, alkali, and organic compounds. Then, after the treatment, water, particularly ultrapure water having a resistivity value of 18MΩ or more, has been used for the purpose of rinsing off the cleaning composition. The reason therefor is to achieve chemical stability in the transfer process or the like in a processing atmosphere by rapidly removing the cleaning composition adhering to the semiconductor surface and, in certain circumstances, by terminating the semiconductor surface with hydrogen atoms. However, this process is for the foregoing purpose and has nothing to do with contribution to maintaining/improving the surface roughness required for the semiconductor surface. Rather, the surface roughness is deteriorated due to a chemical reaction between the semiconductor surface and the water in the water. This point is still not a problem under the current circumstances. However, it is obvious that the miniaturization of semiconductor devises will further advance in future and it is sure to be a problem then.

Therefore, upon forming a compound film such as a gate oxide film on the semiconductor surface, a process is required that enables the surface of an underlying semiconductor to be extremely clean and flat, thereby contributing to manufacturing a highly reliable high-performance semiconductor device.

Many proposals have hitherto been made about semiconductor cleaning methods. For example, Japanese Unexamined Patent Application Publication (JP-A) No. H11-297656 (hereinafter referred to as Patent Document 1) proposes a semiconductor device manufacturing method, a rinsing liquid, and a semiconductor substrate cleaning liquid. On the other hand, Japanese Unexamined PatentApplication Publication (JP-A) No. H11-340183 (hereinafter referred to as Patent Document 2) proposes a semiconductor device cleaning liquid and a semiconductor device manufacturing method using it. In Patent Document 1, a mixture of a glycol-based solvent and water is used for the purpose of selective etching of oxide films of different kinds in cleaning of a semiconductor substrate having silicon oxide-based insulating films. Further, in Patent Document 2, a cleaning liquid containing hydrogen fluoride and alcohol is used for the purpose of removing a sidewall polymer and preventing corrosion of a metal wiring material.

The technique disclosed in Patent Document 1 or 2 is not a precise technique such as etching at the atomic layer level in the semiconductor surface. Further, in certain circumstances, it is considered that, rather than the effect of the additive composition, the semiconductor surface, particularly the pure semiconductor surface having no coating such as an oxide film, is roughened. Therefore, the technique is limited in use and thus is not applicable to the comprehensive semiconductor manufacture. Particularly, it is not a technique that enables the surface of a semiconductor before formation of a semiconductor oxide film to be extremely clean and flat. Accordingly, there has been earnestly desired the development of a cleaning technique that can realize it to improve the performance of semiconductor devices.

Patent Document 1: Japanese Unexamined Patent Application Publication (JP-A) No. H11-297656
Patent Document 2: Japanese Unexamined Patent Application Publication (JP-A) No. H11-340183

Disclosure of the Invention

Problem to be Solved by the Invention

As described above, in order to further improve the performance of semiconductor devices following the miniaturization of devices, there has been earnestly desired the development of a cleaning technique that enables the surface of a semiconductor to be extremely clean and flat.

It is an object of this invention to provide a processing liquid and a processing method, that can form a clean and flat semiconductor surface with only a little dissolution from a semiconductor substrate, and a semiconductor manufacturing apparatus that can form a clean and flat semiconductor surface with only a little dissolution from a semiconductor substrate.

Means for Solving the Problem

For solving the foregoing problems and accomplishing the object, this invention provides a semiconductor surface processing liquid, and a processing method and a manufacturing apparatus using it, which are characterized by processing with an aqueous solution containing at least one kind of alcohols and ketones. By the use of the processing liquid of this application, and the processing method and the manufacturing apparatus using it, there are obtained a process with only a little dissolution from a semiconductor surface and a semiconductor device having a clean and flat surface.

In a processing liquid and a processing method characterized by using an aqueous solution adapted to cause a dissolution amount of atoms from a semiconductor to be 15 atomic layers/24 hours or less by conversion and a semiconductor manufacturing apparatus using them, this invention is characterized by processing with an aqueous solution containing at least one kind of alcohols and ketones. Herein, atomic layers/24 hours being a unit of the dissolution amount of atoms from a semiconductor is a numerical value indicating how many times a numerical value, obtained by dividing the number of dissolved semiconductor atoms calculated from a measured value by an area of a semiconductor crystal used in the measurement, is larger than the number of semiconductor atoms that are present per unit surface area.

This invention is a processing liquid, a processing method, and a semiconductor manufacturing apparatus using them, which are characterized by processing with an aqueous solution containing at least one kind of alcohols and ketones. The processing liquid is at least one kind of the alcohols each having a structure of R1 R2C(OH)R3 (R1 represents one of C1 to C4 alkyl groups having straight and branched chains that may be replaced by halogen and hydroxyl groups. Each of R2 and R3 is the same as or different from R1 and represents one of C1 to C4 alkyl groups having straight and branched chains that may be replaced by halogen and hydroxyl groups, or hydrogen atoms) and the ketones each having a structure of R4C=OR5 (R4 represents one of C1 to C4 alkyl groups having straight and branched chains that may be replaced by halogen and hydroxyl groups. R5 is the same as or different from R4 and represents one of C1 to C4 alkyl groups having straight and branched chains that may be replaced by halogen and hydroxyl groups, or hydrogen atoms). It is preferable that water to be used be so-called ultrapure water having a resistivity value of 18MΩ or more.

The center line average roughness (Ra) of a semiconductor surface formed by the processing liquid, the processing method, and the semiconductor manufacturing apparatus of this invention is 0.15nm or less, preferably 0.1 nm or less, and more preferably 0.07nm or less.

This invention is a processing liquid, a processing method, and a semiconductor manufacturing apparatus using them, wherein the processing liquid is at least one kind of compounds in which the alcohols and the ketones have structures comprised of C1 to C7 alkyl groups or alkyl groups containing halogen or heteroatoms. The alcohols are preferably, for example, methyl alcohol, ethyl alcohol, 1-propanol, 1-butanol, 2-butanol, and so on, and more preferably 2-propanol. Further, they may be polyhydric alcohols having two or more hydroxyl groups.

The ketones are preferably, for example, ethyl methyl ketone, diethyl ketone, and so on, and more preferably acetone. Further, they may be partially replaced by halogen atoms such as fluorine. The alcohols and ketones to be used are not limited to one kind and two or more kinds may be mixed. For example, as a combination thereof, one kind from the alcohols and one kind from the ketones may be mixed.

The alcohols and the ketones for use in the processing liquid, the processing method, and the semiconductor manufacturing apparatus of this invention each have a relative permittivity of 82 or less and are preferably, specifically, methyl alcohol, ethyl alcohol, diethyl ketone, and so on, and more preferably 2-propanol, acetone, and so on.

2-propanol is preferably used as alcohol of this invention and may be mixed with alcohols and ketones. Preferably, there are, specifically, methyl alcohol, ethyl alcohol, diethyl ketone, acetone, and so on.

The alcohols and the ketones each have a purity of 99 mass% or more and preferably 99.9 mass% or more. The total amount of metal impurities is preferably 0.1 ppm or less and more preferably 1 ppb or less.

This invention is characterized in that the concentration of alcohols and ketones contained in the processing liquid, the processing method, and the semiconductor manufacturing apparatus using them is 5 mass% or more, preferably 10 mass% or more, and more preferably 30 mass% or more.

The processing method is characterized by using a semiconductor single crystal as a to-be-processed structure of the processing liquid, the processing method, and the semiconductor manufacturing apparatus of this invention. Specifically, for example, silicon is used as the semiconductor material. There is no limitation to a plane orientation of the single crystal to be processed and it may be, for example, (100), (111). (110), or the like. It is also applicable to a plane properly offset with respect to such a plane orientation.

The processing method is characterized by using a semiconductor polycrystal as a to-be-processed structure of the processing liquid, the processing method, and the semiconductor manufacturing apparatus of this invention. Specifically, for example, polysilicon is used as the semiconductor polycrystal. Further, the processing method is characterized by using an amorphous semiconductor as the foregoing to-be-processed structure. Further, the processing method is characterized by using a semiconductor compound as the foregoing to-be-processed structure. Specifically, for example, it is gallium arsenide or the like.

A feature of this invention is a processing liquid containing at least one or more of hydrochloric acid, nitric acid, sulfuric acid, acetic acid, hydrofluoric acid, and ammonium fluoride, and a processing method and a semiconductor manufacturing apparatus using such a processing liquid.

This invention is characterized by dissolving one or more kinds of nitrogen, hydrogen, oxygen, and ozone into water for use in the processing liquid, the processing method, and the semiconductor manufacturing apparatus. For example, it is preferable to dissolve hydrogen gas in a dissolution amount of 1 ppb or the like.

This invention is a processing method and a semiconductor manufacturing apparatus characterized by comprising a step of removing alcohols and ketones adhering to a semiconductor surface after a processing step using an aqueous solution containing one or more kinds of alcohols and ketones, wherein, preferably, the semiconductor surface is heated, and more preferably, a processing atmosphere is filled with oxygen gas. Specifically, for example, a to-be-processed semiconductor structure is heated to 450°C. The temperature of the semiconductor and the oxygen gas concentration upon heating are not limited thereto and may be more or less than them.

This invention is a processing method characterized by comprising a step of generating a plasma using an excited gas species, thereby removing alcohols and ketones adhering to a semiconductor surface, and a semiconductor manufacturing apparatus using such a processing method. The gas species to be used is characterized by being at least one of argon, krypton, and xenon. Two or more of the gases may be mixed. The gas pressure and so on are properly selectable and thus are not limitative.

This invention is a processing method characterized by using the plasma generated by exciting the gas species with an electromagnetic wave in the foregoing plasma generating method, and a semiconductor manufacturing apparatus using such a processing method. Herein, the electromagnetic wave is only required to have energy to excite the gas species and, specifically, is preferably a microwave.

This invention is a processing method characterized by heating a to-be-processed structure in a step of using a plasma for removing adhered alcohols and ketones, and a semiconductor manufacturing apparatus using such a processing method. Upon heating, the temperature of the semiconductor is preferably 400°C, but is not limited to such a temperature.

This invention is a processing method characterized by covering part of a to-be-processed structure With a semiconductor oxide layer, and a semiconductor manufacturing apparatus using such a processing method. It is preferable to configure such that part of the semiconductor that is not subjected to a plasma caused by an excited gas is covered with the semiconductor oxide layer. Specifically, for example, when silicon is used as the semiconductor, it is preferably to cover with a silicon oxide film. Herein, the film may be any film as long as it is an oxide film.

This invention is a processing method characterized by recovering a processing liquid used in a processing step and reusing it after purification, and a semiconductor manufacturing apparatus using such a processing method. Herein, the purification may be any step as long as it is a step of removing impurities generated during the processing. For example, it may be ion exchange resin or the like.

This invention is a processing method characterized by suppressing an oxygen gas concentration of an atmosphere in a semiconductor processing step, wherein a main gas species is nitrogen, and a semiconductor manufacturing apparatus using such a processing method. The oxygen concentration is preferably set to 20ppm or less and more preferably 5ppm or less.

This invention is a processing method characterized by suppressing an oxygen gas concentration of an atmosphere in a semiconductor processing step, wherein a main gas species is a mixture of nitrogen and hydrogen, and a semiconductor manufacturing apparatus using such a processing method. The oxygen concentration is preferably set to 20ppm or less and more preferably 5ppm or less. The hydrogen gas concentration is not limited as long as it is 4% or less.

Effect of the Invention

According to this invention, by processing a surface of a semiconductor using an aqueous solution containing at least one kind of alcohols and ketones, it is possible to suppress dissolution of semiconductor constituent atoms from the semiconductor surface to 15 atomic layers/24 hours or less. Further, the surface roughness of the semiconductor after the processing can be set to 0.10nm or less as compared with a surface roughness of about 1.0nm obtained by the conventional RCA cleaning technique. Therefore, the improvement in performance of a semiconductor device can be expected. Further, by filling a processing atmosphere with a proper gas, there is an effect of suppressing formation of a film such as a natural oxide film that causes deterioration in properties of a semiconductor device.

Further, according to this invention, by providing a step of removing alcohols and ketones adhering to a semiconductor surface after processing the semiconductor surface using an aqueous solution containing at least one kind of alcohols and ketones, there occurs no deterioration in properties such as lowering of a dielectric-breakdown electric field caused by adhered alcohols remaining in a structure stacked on the semiconductor surface, which has been a problem in the conventional semiconductor manufacturing technique using alcohol. Further, by the use of a plasma excited by a microwave, there is obtained a similar processing effect at a lower temperature as compared with a conventional removal method using heat.

Furthermore, according to this invention, by recovering a processing liquid used in processing a semiconductor surface with an aqueous solution containing at least one kind of alcohols and reusing it after purification, the amount of use of alcohol can be reduced.

According to a processing liquid and a processing method for a semiconductor device, and a semiconductor manufacturing apparatus of the invention of this application, there are obtained the processing liquid, the processing method, and the semiconductor manufacturing apparatus that realize a process with only a little dissolution from a semiconductor surface and a clean and flat surface.

Brief Description of the Drawings

[Fig. 1] is a flow diagram of an RCA cleaning method.
[Fig. 2] is a flow diagram of gate oxide film formation according to an embodiment 1.
[Fig. 3] is sectional views of a semiconductor substrate in the processing stages of a gate oxide film forming process according to the embodiment 1.
[Fig. 4] is a flow diagram of gate oxide film formation according to an embodiment 2.
[Fig. 5] is sectional views of a semiconductor substrate in the processing stages of a gate oxide film forming process according to the embodiment 2.
[Fig. 6] is a processing flow diagram having a processing liquid recovery purification mechanism according to an embodiment 3.
[Fig. 7] is a correlation diagram between the atom dissolution amount and the alcohol concentration according to Example 1 and Comparative Example 1.
[Fig. 8] is a correlation diagram between the center line average roughness and the alcohol concentration according to Example 1 and Comparative Example 1.
[Fig. 9] is a diagram showing alcohol desorption states by a thermal desorption method according to Example 2 and Comparative Example 2.
[Fig. 10] is a correlation diagram between the atom dissolution amount and the alcohol purity according to Example 3.

Description of Symbols

1    semiconductor substrate
2    silicon oxide film
3    silicon nitride film
4    field oxide film
5    preoxide film
6    gate oxide film
7    adhered matter

Best Mode for Carrying Out the Invention

Hereinbelow, referring to the drawings, description will be made of processing liquids and processing methods for semiconductor devices, and semiconductor manufacturing apparatuses according to this invention.

Embodiment 1

The embodiment 1 of this invention is such that an aqueous solution adapted to cause a dissolution amount of atoms from a semiconductor substrate to be 15 atomic layers/24 hours or less by conversion is used when processing the semiconductor substrate, thereby improving a processing liquid and a processing method. In the embodiment 1, description will be made of these processing liquid and processing method and a semiconductor manufacturing apparatus using them in the manufacture of a semiconductor device.

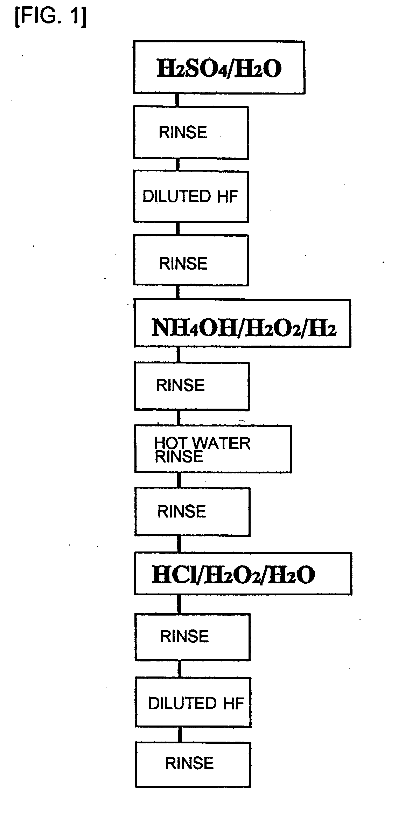

This invention is applicable to various process sequences that are based on features of various processing liquids currently used in the semiconductor manufacturing processes. Fig. 1 shows one example of an RCA cleaning method as a processing process. The various process sequences each use a treatment with a water rinse as a rinsing process and this invention proposes a method of improving those water rinsing processes. Therefore, this invention is not limited to a process that uses a specific water rinse, but is also applicable to a treatment before formation of a gate oxide film and cleaning of contact holes, via holes, capacitors, and so on.

Herein, description will be given using an example where this invention is applied as a pretreatment of a thermal oxidation process, i.e. so-called gate oxide film formation, generally employed as an initial process in the manufacture of a semiconductor device such as the manufacture of a DRAM (Dynamic Random Access Memory). This process is not limited to the DRAM manufacture, but is used for various LSI manufacturing processes.

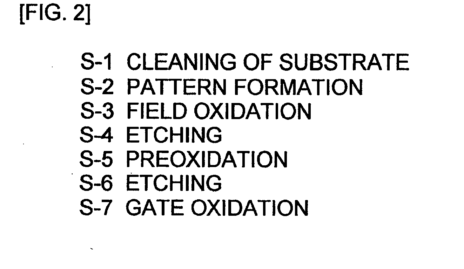

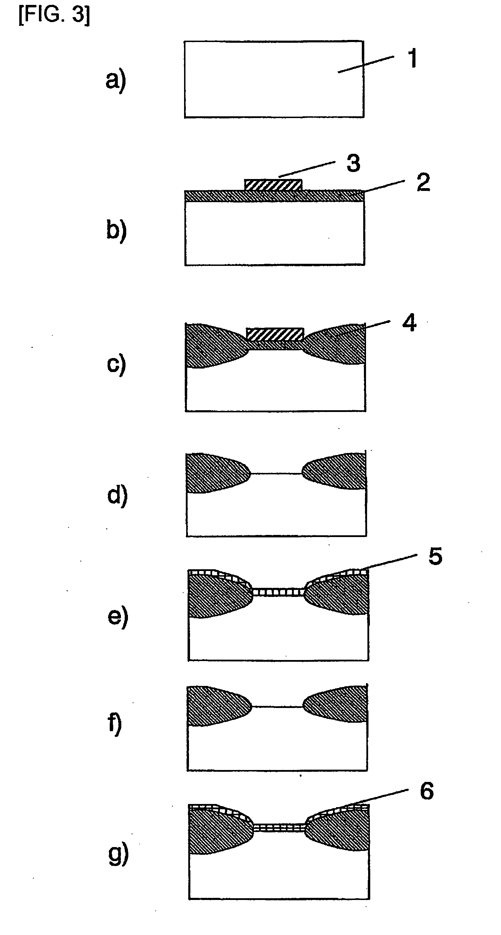

Fig. 2 shows an example of a gate oxide film forming process and Fig. 3 shows sectional views of a semiconductor substrate in the processing stages of the gate oxide film forming process. There is prepared a semiconductor substrate 1 made of a silicon single crystal, shown at a) in Fig. 3. After cleaning the semiconductor substrate (step: S-1 in Fig. 2), a silicon oxide film 2 and a silicon nitride film 3 shown at b) in Fig. 3 are formed. After pattern formation by photolithography (step: S-2 in Fig. 2), a field oxide film 4 shown at c) in Fig. 3 is formed (step: S-3 in Fig. 2).

Thereafter, as shown at d) in Fig. 3, the silicon nitride film 3 is etched and the silicon oxide film 2 is also etched using an HF-based chemical solution (step: S-4 in Fig. 2), thereby exposing the surface of the silicon substrate in a gate region. Thereafter, a preoxide film 5 shown at e) in Fig. 3 is formed (step: S-5 in Fig. 2) and, using an HF-based chemical solution, the formed oxide film is etched as shown at f) in Fig. 3 (step: S-6 in Fig. 2). Thereafter, a gate oxide film 6 shown at g) in Fig. 3 is formed (step: S-7 in Fig. 2).

This invention can be used in rinsing processes of the foregoing steps such as the cleaning of the semiconductor substrate (S-1 in Fig. 2), the etching of the gate-region oxide films by the field oxide film etching (S-4 in Fig. 2), and the etching of the preoxide film (S-6 in Fig. 2). By using this invention in the respective steps before the gate oxidation, it is possible to suppress dissolution of atoms from the semiconductor substrate and thus suppress the surface roughness of the interface between the gate oxide film to be formed and the semiconductor substrate, thereby enabling the improvement in performance of a semiconductor device to be manufactured. It is known that the improvement in flatness of the interface between the gate oxide film and the silicon substrate as shown in the figure largely improves the performance of the semiconductor device to be manufactured.

Embodiment 2

The embodiment 2 of this invention is characterized by comprising a step of removing alcohols and ketones adhering to a semiconductor surface after processing a semiconductor substrate using an aqueous solution containing at least one or more kinds of alcohols and ketones. In the embodiment 2, description will be made of a processing method and a semiconductor manufacturing apparatus in the case where there are applied a treatment using a processing liquid containing at least one or more kinds of alcohols and ketones and an alcohol/ketone removal step thereafter in the manufacture of a semiconductor device.

As alcohols and ketones to be used, there can be cited, as examples, methanol, ethanol, 1-propanol, 2-propanol, 1-butanol, 2-butanol, tert-butyl alcohol, 1-pentanol, 2-pentanol, acetone, diethyl ketone, ethyl methyl ketone, and so on. If the following conditions are satisfied, for example, 1,3-fluoro-2-propanol and difluoromethyl ketone may be cited as alcohol and ketone.

The following alcohols and ketones can be used for a processing liquid. The alcohols each have a structure of R1 R2C(OH)R3, where R1 represents one of C1 to C4 alkyl groups having straight and branched chains that may be replaced by halogen and hydroxyl groups and each of R2 and R3 is the same as or different from R1 and represents one of C1 to C4 alkyl groups having straight and branched chains that may be replaced by halogen and hydroxyl groups, or hydrogen atoms. The ketones each have a structure of R4C=OR5, where R4 represents one of C1 to C4 alkyl groups having straight and branched chains that may be replaced by halogen and hydroxyl groups and R5 is the same as or different from R4 and represents one of C1 to C4 alkyl groups having straight and branched chains that may be replaced by halogen and hydroxyl groups, or hydrogen atoms. Use is made of an aqueous solution containing at least one kind of alcohols and ketones expressed by such molecular structures. It is preferable that water to be used be so-called ultrapure water having a resistivity value of 18MΩ or more.

It may also be an aqueous solution containing at least one kind of compounds in which the alcohols and the ketones have structures comprised of C1 to C7 alkyl groups or alkyl groups containing halogen or heteroatoms. The alcohols are preferably, for example, methyl alcohol, ethyl alcohol, 1-propanol, 1-butanol, 2-butanol, and so on, and more preferably 2-propanol. Further, they may be polyhydric alcohols having two or more hydroxyl groups. The ketones are preferably, for example, ethyl methyl ketone, diethyl ketone, and so on, and more preferably acetone. Further, they may be partially replaced by halogen atoms such as fluorine. The alcohols and ketones to be used are not limited to one kind and two or more kinds may be mixed. For example, as a combination thereof, one kind from the alcohols and one kind from the ketones may be mixed.

The alcohols and the ketones for use in the processing liquid, the processing method, and the semiconductor manufacturing apparatus of this invention each have a relative permittivity of 82 or less and are preferably, specifically, methyl alcohol, ethyl alcohol, diethyl ketone, and so on, and more preferably 2-propanol, acetone, and so on.

2-propanol is preferably used as alcohol of this invention and may be mixed with alcohols and ketones. Preferably, there are, specifically, methyl alcohol, ethyl alcohol, diethyl ketone, acetone, and so on.

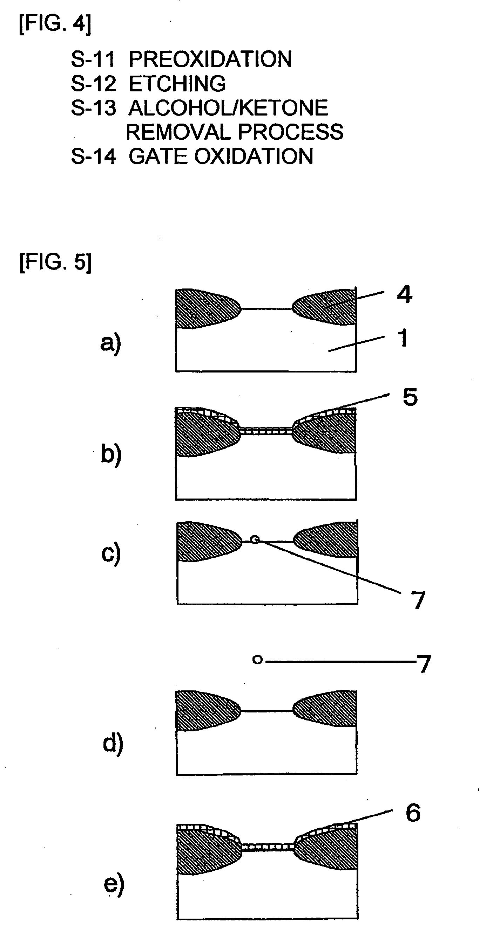

Fig. 4 shows an example of a gate oxide film forming process using this invention and Fig. 5 shows sectional views of a semiconductor substrate in the processing stages of the gate oxide film forming process. A silicon semiconductor substrate 1 is prepared as shown at a) in Fig. 5. This substrate is in the state where a field oxide film 4 is already selectively formed. Thereafter, a preoxide film 5 shown at b) in Fig. 5 is formed (step: S-11 in Fig. 4) and the formed oxide film is etched using an HF-based chemical solution as shown at c) in Fig. 5 (step: S-12 in Fig. 4). Thereafter, as shown at d) in Fig. 5, a heat treatment is performed in an oxygen gas atmosphere for removing alcohols and ketones (7 at d) in Fig. 5) adhering to the semiconductor substrate in a gate region (step: S-13 in Fig. 4). Thereafter, a gate oxide film 6 shown at e) in Fig. 5 is formed (step: S-14 in Fig. 4).

The removal process in S-13 in Fig. 4 is exemplified by the heating in the oxygen gas atmosphere. Although heating of only the semiconductor surface may be acceptable, it is preferable to fill a processing atmosphere with oxygen gas. Specifically, for example, a to-be-processed semiconductor structure is heated to 450°C. The temperature of the semiconductor and the oxygen gas concentration when heating are riot limited thereto and may be more or less than them. Further, it is preferable to remove alcohols and ketones using a plasma. Description will be made of removal of alcohols and ketones using a plasma, and so on.

With respect to a plasma process, a plasma generating method may be a parallel-plate type or the like and there is no particular limitation thereto. However, it is preferably a plasma generating method using a radial line slot antenna, in which a plasma can be uniformly applied to the substrate surface by exciting a gas species with an electromagnetic wave. Herein, the electromagnetic wave is only required to have energy to excite the gas species and, specifically, is preferably a microwave. When using a plasma and heating a to-be-processed semiconductor device (structure), the temperature of the semiconductor device is preferably 400°C, but is not limited to such a temperature.

When using a plasma, a noble gas, preferably xenon, krypton, argon, or the like is cited as a gas species for exciting the plasma. Since damage to the semiconductor substrate can be reduced using a gas species having a large collision cross section, the gas species is preferably xenon among the foregoing noble gases. Two or more of the foregoing gases may be mixed. The gas pressure and so on are properly selectable and thus are not limitative.

With respect to the foregoing alcohol/ketone removal method using the plasma, for example, the back side or the like of the silicon substrate is specifically cited as a portion of the to-be-processed semiconductor device where the plasma is not irradiated, and it is preferable to cover such a portion with a silicon oxide film in advance. Herein, the film may be any film as long as it is an oxide film. By configuring such that the part of the semiconductor that is not subjected to the plasma caused by the excited gas is covered with the semiconductor oxide layer, the removal of alcohols and ketones is facilitated. Thus, it is possible to further suppress the adhesion amount of the organic solvent.

Therefore, the organic impurities on the interface between the gate oxide film and the silicon substrate can be reduced by the removal of alcohols and ketones, so that it is possible to suppress the deterioration in performance of the semiconductor device to be manufactured.

Embodiment 3

The embodiment 3 is a processing method characterized by recovering a processing liquid used in a processing step and reusing it after purification. Description will be made of a configuration in which a mechanism therefor is added to the semiconductor manufacturing process.

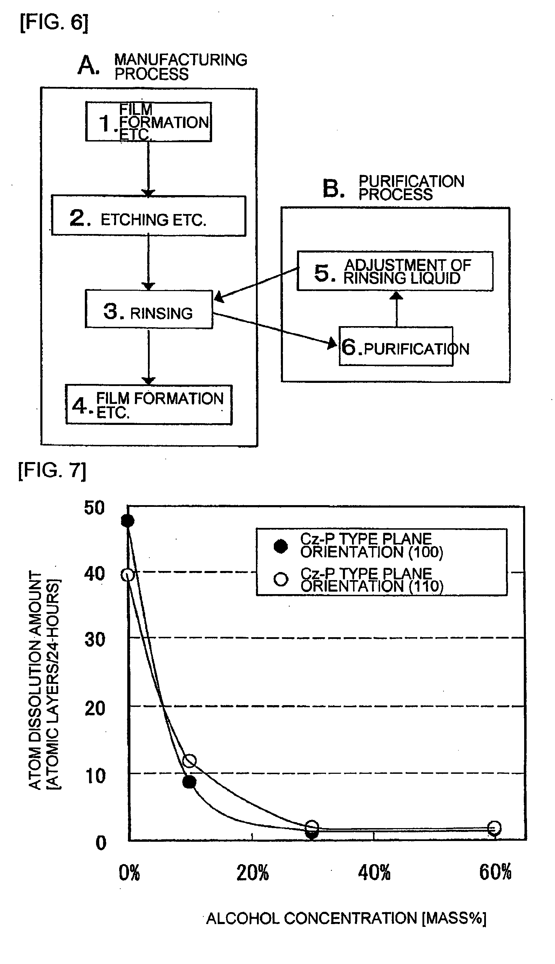

Fig. 6 is a schematic diagram of the processing process having the foregoing processing liquid recovery purification mechanism. Part of the semiconductor manufacturing process is extracted and shown at 1 to 4 in Fig. 6. In this invention, a processing liquid used at 3 in Fig. 6 is recovered to a purification step at 6 in Fig. 6. After the recovery, the recovered processing liquid is adjusted to a composition, in a rinsing liquid adjusting step at 5 in Fig. 6, suitable for a subsequent step and then it is reused.

The purpose of the purification is to remove the impurities. Ultrafiltration, reverse osmosis membrane, or the like can be used for particulate impurities. Metal impurities can be removed by adopting a proper ion exchange resin, or the like. There is no limitation to a recovering step or a reusing step. Recovery from a plurality of rinsing steps or the like in a sequence of the semiconductor manufacturing process and reuse in such steps are made possible. Distillation or the like is suitable for purification of alcohols and ketones.

Accordingly, water and alcohols and ketones for use in semiconductor processing can be reduced by the processing method and the semiconductor manufacturing apparatus of this invention.

Embodiment 4

The embodiment 4 of this invention is a processing method and a semiconductor manufacturing apparatus characterized by suppressing an oxygen gas concentration of an atmosphere in the semiconductor processing process, which will be described.

In the semiconductor manufacturing process, it is preferable that steps from cleaning of a substrate to completion of a semiconductor device be carried out in an atmosphere where the oxygen gas concentration is suppressed. Specifically, the oxygen gas concentration is preferably set to 20ppm or less and more preferably 5ppm or less, and a main gas species occupying the other part is preferably nitrogen. The main gas species may be a mixture of nitrogen and hydrogen. The hydrogen gas concentration is not limited as long as it is 4% or less. By controlling these atmospheric gases, it is possible to suppress formation of a natural oxide film that causes deterioration in performance of a semiconductor device in the semiconductor manufacture. There is no particular limitation to realization of the foregoing atmosphere except an application method that deviates from the principle in the semiconductor manufacture, and it can be realized by providing inlet ports and flow rate control mechanisms for those gas species in the semiconductor manufacturing apparatus.

As a semiconductor device manufacturing type of the semiconductor manufacturing apparatus, there is no particular limitation except a manufacturing type that deviates from the principle in the semiconductor manufacture, and thus a processing method is not limited and may be of a batch type, a single-wafer type, or the like. It is preferable to use a semiconductor manufacturing apparatus capable of single-wafer type processing which has an advantage in terms of processing uniformity.

Example 1

Hereinbelow, Examples of this invention will be described in detail with reference to the drawings. Example 1 is an example where solutions obtained by adding 10 to 60 mass% isopropanol to ultrapure water were used as processing liquids. Although isopropanol is used as alcohols and ketones in this Example 1, it is, of course, possible to optionally select from the alcohols and ketones within the range indicated in the foregoing embodiments. Semiconductor substrates to be used in processing were subjected to RCA cleaning in advance. The semiconductor substrates after the cleaning were immersed in a nitrogen atmosphere for 24 hours and then were taken out. Then, the dissolution amounts of semiconductor atoms into the processing liquids and the surface roughness were measured.

Inductively coupled plasma-atomic emission spectrometry (ICP-AES) was used for evaluating the dissolution amounts of semiconductor atoms into the processing liquids. The dissolution amounts were compared using a unit of atomic layers/24 hours. Atomic layers/24 hours being a unit of the dissolution amount of atoms from a semiconductor is a numerical value indicating how many times a numerical value, obtained by dividing the number of dissolved semiconductor atoms calculated from a measured value by an area of a semiconductor crystal used in the measurement, is larger than the number of semiconductor atoms that are present per unit area.

The surface roughness was evaluated using an atomic force microscope of Seiko Instruments Inc. The center line average roughness (Ra) was used as a unit. Ra is a value calculated by the following numerical formula 1 given that a portion with a measurement length l is extracted from a cross-sectional curve along the direction of its center line, the center line of the extracted portion is set to the X-axis, the direction of longitudinal magnification is set to the Y-axis, and the cross-sectional curve is expressed by $y=f(x)$.

## [Formula 1]

$$Ra = \frac{1}{l}\int_0^l |f(x)|dx$$

The semiconductor substrates to be used in the processing were subjected to the cleaning in advance. The semiconductor substrates after the cleaning were immersed in the nitrogen atmosphere for 24 hours and then were taken out. Investigation of the dissolution amounts of semiconductor atoms was performed using the inductively coupled plasma-atomic emission spectrometry (ICP-AES) and, based on the spectrometry results, the dissolution amounts were compared using the unit of atomic layers/24 hours. The surface roughness was evaluated using the atomic force microscope of Seiko Instruments Inc. and Ra was calculated based on the observation results.

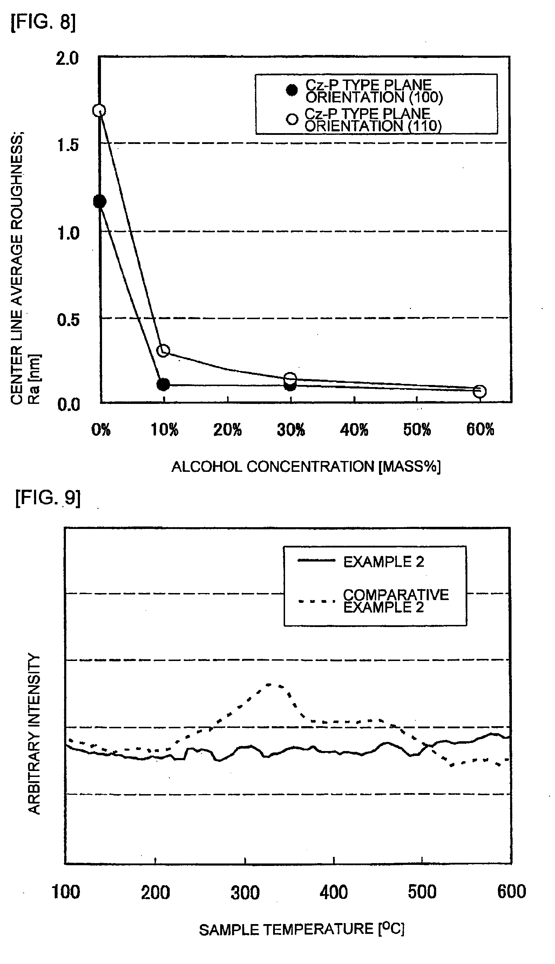

The treatment using the ultrapure water added with the alcohol and a treatment using only pure water as Comparative Example 1 were carried out. Fig. 7 shows the dissolution amounts of semiconductor atoms into the processing liquids after the treatment and Fig. 8 shows the results of the surface roughness measurement. An alcohol concentration of 0 mass% in each figure corresponds to the results of Comparative Example 1. From these figures, effects are obtained by setting alcohols and ketones to 5 mass% or more, preferably 10 mass% or more, and more preferably 30 mass% or more. In this event, there are obtained 15 atomic layers/24 hours or less as the atom dissolution amount and a semiconductor center line average roughness (Ra) of 0.15nm or less as the surface roughness. The semiconductor center line average roughness (Ra) is preferably 0.1nm or less and more preferably 0.07nm or less.

With respect to a to-be-processed structure, there is cited a semiconductor single crystal, specifically, for example, silicon as a semiconductor material. As the crystal dependence in silicon, plane orientations (100) and (110) are shown as examples. These exhibit substantially the same results. There is no limitation to a plane orientation of a single crystal to be processed and it may be, for example, (100), (111), (110), or the like. It is also applicable to a plane properly offset with respect to such a plane orientation. Further, it is applicable to a semiconductor polycrystal and, specifically, for example, polysilicon as the semiconductor polycrystal. Further, it is also applicable to an amorphous semiconductor or a semiconductor compound and, specifically, for example, gallium arsenide or the like as the semiconductor compound.

In this Example, it is understood that the dissolution amount of semiconductor atoms into the processing liquid can be suppressed by the treatment using the chemical solution added with the alcohol as shown in Fig. 7. Further, according to Fig. 8, it is understood that the surface with a small surface roughness can be obtained by the treatment based on this invention. With respect to the semiconductor surface formed by the processing liquid, the processing method, and the semiconductor manufacturing apparatus of this invention, the dissolution amount of semiconductor atoms into the processing liquid can be suppressed, resulting in a small surface roughness.

Example 2

Example 2 is an example where a solution obtained by adding 30 mass% 2-propanol to ultrapure water was used as a processing liquid and further an alcohol removal step was carried out. In this Example 2, 2-propanol was used as alcohols and ketones. A semiconductor substrate to be used in processing was subjected to RCA cleaning in advance. The semiconductor substrate after the cleaning was immersed in the foregoing cleaning liquid for 10 minutes and then was processed under the conditions that a plasma was generated using xenon gas, thereby removing the adhered alcohol. Evaluation after the treatment was performed by thermal desorption spectrometry and an analysis of desorbed matter was performed using atmospheric pressure ionization mass spectrometry.

As Comparative Example 2, a solution obtained by adding 30 mass% 2-propanol to ultrapure water was used as a processing liquid. A semiconductor substrate to be used in processing was subjected to RCA cleaning in advance. The semiconductor substrate after the cleaning was immersed in the foregoing cleaning liquid for 10 minutes. Evaluation after the treatment was performed by the thermal desorption spectrometry and an analysis of desorbed matter was performed using the atmospheric pressure ionization mass spectrometry. Comparative Example 2 is a sample that does not perform the plasma processing being the alcohol removal step in Example 2.

The results of the foregoing Example 2 and Comparative Example 2 are shown in Fig. 9. In the figure, the axis of ordinates represents a relative intensity of the mass spectrometer and the axis of abscissas represents a substrate temperature. Since it is known that mass number 43 is recognized as a signal caused by 2-propanol in the mass spectrometry, Fig. 9 shows the intensity of a signal of mass number 43. According to Fig. 9, a signal caused by 2-propanol appears from 250°C to 500°C in the case of Comparative Example 2 where no plasma processing is performed, while, such a signal is not observed in the case of Example 2 where the plasma processing is performed. Therefore, the adhered alcohol can be removed by the treatment using the plasma according to this invention.

Example 3

Example 3 is an example where solutions obtained by adding 30 mass% 2-propanol to ultrapure water were used as processing liquids, wherein 2-propanol having different purities was used. Semiconductor substrates to be used in processing were subjected to cleaning in advance. The semiconductor substrates after the cleaning were immersed in a nitrogen atmosphere for 24 hours and then were taken out. Then, the dissolution amounts of semiconductor atoms into the processing liquids and the surface roughness were measured.

Inductively coupled plasma-atomic emission spectrometry (ICP-AES) was used for evaluating the dissolution amounts of semiconductor atoms into the processing liquids. The dissolution amounts were compared using a unit of atomic layers/24 hours. Atomic layers/24 hours being a unit of the dissolution amount of atoms from a semiconductor is a numerical value indicating how many times a numerical value, obtained by dividing the number of dissolved semiconductor atoms calculated from a measured value by an area of a semiconductor crystal used in the measurement, is larger than the number of semiconductor atoms that are present per unit area.

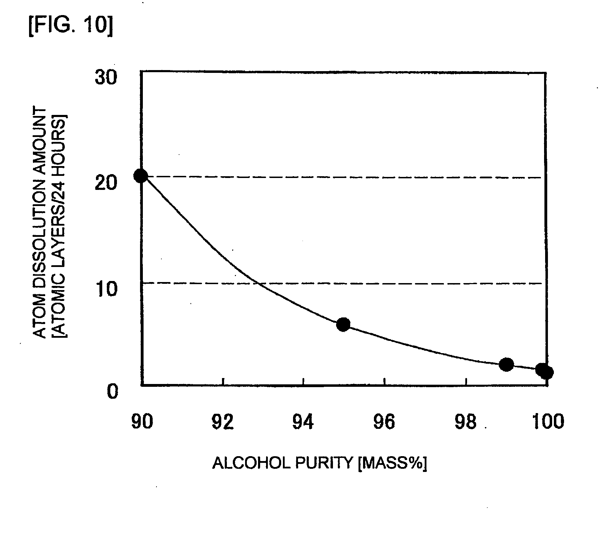

Fig. 10 shows the relationship between the purity of 2-propanol and the semiconductor atom dissolution amount. As shown in Fig. 10, a dissolution amount suppression effect is observed with a purity of 99 mass% or more while the dissolution amount increases as the purity decreases. A catalytic effect due to impurities, or the like may be considered. By setting the purity of alcohol to be used to a high value, the process with only a little semiconductor atom dissolution amount in this invention is enabled. Therefore, the purity of alcohols and ketones is 99 mass% or more and preferably 99.9 mass% or more. The total amount of metal impurities is preferably 0.1 ppm or less and more preferably 1 ppb or less.

Example 4

Example 4 is an example where a solution obtained by adding 30 mass% 2-propanol to ultrapure water was used as a processing liquid and treatments were performed in a normal atmospheric atmosphere and an atmosphere filled with a nitrogen gas in which the oxygen gas concentration was controlled to 5ppm or less. Semiconductor substrates to be used in processing were subjected to cleaning in advance. The semiconductor substrates after the cleaning were immersed in a nitrogen atmosphere for 24 hours and then were taken out. Then, the dissolution amounts of semiconductor atoms into the processing liquids were measured.

Inductively coupled plasma-atomic emission spectrometry (ICP-AES) was used for evaluating the dissolution amounts of semiconductor atoms into the processing liquids. The dissolution amounts were compared using a unit of atomic layers/24 hours. Atomic layers/24 hours being a unit of the dissolution amount of atoms from a semiconductor is a numerical value indicating how many times a numerical value, obtained by dividing the number of dissolved semiconductor atoms calculated from a measured value by an area of a semiconductor crystal used in the measurement, is larger than the number of semiconductor atoms that are present per unit area.

Table 1 shows the relationship between the kind of processing atmosphere and the semiconductor atom dissolution amount.

[Table 1]

| Processing Atmosphere Processing Atmosphere | Atom Dissolution Amount (Atomic Layers/24hr) |
|---|---|
| Atmospheric Atmosphere | 4.3 |
| Nitrogen Gas Atmosphere (Oxygen Gas Concentration 5ppm or less) | 1.2 |

As seen from Table 1, the number of atoms to be dissolved can be further reduced by lowering the oxygen gas concentration of the processing atmosphere. By performing the treatment with the aqueous solution containing at least one or more kinds of alcohols and ketones in the environment filled with the nitrogen gas and so on, the number of atoms to be dissolved can be reduced, which leads to the improvement in semiconductor performance.

The processing liquid of this application is the aqueous solution containing alcohols and ketones. It may also be a processing liquid containing at least one or more of hydrochloric acid, nitric acid, sulfuric acid, acetic acid, hydrofluoric acid, and ammonium fluoride. Further, it is possible to dissolve one or more kinds of nitrogen, hydrogen, oxygen, and ozone into water for use in the processing liquid. For example, hydrogen gas may be dissolved in a dissolution amount of 1 ppb or the like.

While the invention of this application has been described in terms of the embodiments and Examples, it goes without saying that the invention is not limited thereto, but can be subjected to various changes within a range not departing from the gist thereof.

Industrial Applicability

According to a processing liquid, a processing method, and a semiconductor manufacturing apparatus of this invention, the number of atoms dissolved from a semiconductor surface is reduced and there is obtained a semiconductor device having a clean and flat semiconductor surface with a roughness of 0.1 nm or less. It is expected that the problem of semiconductor devices due to the roughness of semiconductor surfaces, which has not currently been actualized, will be actualized following the miniaturization of devices in future. In the manufacture of semiconductor devices in which device miniaturization further advances, this invention can be used for realizing highly reliable high-performance semiconductor devices in future.

**Claims**

1.  A processing liquid, comprising an aqueous solution adapted to cause a dissolution amount of atoms from a semiconductor to be 15 atomic layers/24 hours or less by conversion.

2.  A processing liquid, comprising an aqueous solution containing at least one kind of alcohols and ketones.

3.  A processing liquid according to claim 2, wherein said aqueous solution contains at least one kind of the alcohols each having a structure of R1 R2C(OH)R3 (R1 represents one of C1 to C4 alkyl groups having straight and branched chains that may be replaced by halogen and hydroxyl groups. Each of R2 and R3 is the same as or different from R1 and represents one of C1 to C4 alkyl groups having straight and branched chains that may be replaced by halogen and hydroxyl groups, or hydrogen atoms.) and the ketones each having a structure of R4C=OR5 (R4 represents one of C1 to C4 alkyl groups having straight and branched chains that may be replaced by halogen and hydroxyl groups. R5 is the same as or different from R4 and represents one of C1 to C4 alkyl groups having straight and branched chains that may be replaced by halogen and hydroxyl groups, or hydrogen atoms.).

4.  A processing liquid according to claim 2, wherein said aqueous solution contains at least one kind of compounds in which said alcohols and said ketones have structures comprised of C1 to C7 alkyl groups or alkyl groups containing halogen or heteroatoms.

5.  A processing liquid according to claim 2, wherein said aqueous solution contains at least one kind of compounds in which said alcohols and said ketones each have a relative permittivity of 82 or less.

6.  A processing liquid according to claim 2, wherein said one kind of alcohols is 2-propanol.

7.  A processing liquid according to claim 2, wherein each of said alcohols and said ketones has a purity of 99 mass% or more and contains metal impurities in total amount of 0.1 ppm or less.

8.  A processing liquid according to claim 3, wherein each of said alcohols and said ketones has a purity of 99 mass% or more and contains metal impurities in total amount of 0.1 ppm or less.

9.  A processing liquid according to claim 4, wherein each of said alcohols and said ketones has a purity of 99 mass% or more and contains metal impurities in total amount of 0.1 ppm or less.

10. A processing liquid according to claim 2, wherein a concentration of said at least one kind of alcohols and ketones is 5 mass% or more.

11. A processing liquid according to claim 3, wherein a concentration of said at least one kind of alcohols and ketones is 5 mass% or more.

12. A processing liquid according to claim 4, wherein a concentration of said at least one kind of alcohols and ketones is 5 mass% or more.

13. A processing liquid according to claim 2, comprising at least one or more of hydrochloric acid, nitric acid, sulfuric acid, acetic acid, hydrofluoric acid, and ammonium fluoride.

14. A processing liquid according to claim 3, comprising at least one or more of hydrochloric acid, nitric acid, sulfuric acid, acetic acid, hydrofluoric acid, and ammonium fluoride.

15. A processing liquid according to claim 4, comprising at least one or more of hydrochloric acid, nitric acid, sulfuric acid, acetic acid, hydrofluoric acid, and ammonium fluoride.

16. A processing liquid according to claim 2, wherein one or more kinds of nitrogen, hydrogen, oxygen, and ozone are dissolved into water for use in the processing liquid.

17. A processing liquid according to claim 3, wherein one or more kinds of nitrogen, hydrogen, oxygen, and ozone are dissolved into water for use in the processing liquid.

18. A processing liquid according to claim 4, wherein one or more kinds of nitrogen, hydrogen, oxygen, and ozone are dissolved into water for use in the processing liquid.

19. A processing method, comprising processing a to-be-processed structure by using the processing liquid according to any of claims 1 to 18.

20. A processing method according to claim 19, wherein a center line average roughness (Ra) of a semiconductor surface formed by said processing method is 0.1 nm or less.

21. A processing method according to claim 19, wherein a semiconductor single crystal or a plane offsetting the semiconductor single crystal is used as said to-be-processed structure.

22. A processing method according to claim 19, wherein a silicon semiconductor is used as the semiconductor single crystal that serves as said to-be-processed structure.

23. A processing method according to claim 19, wherein a semiconductor polycrystal is used as said to-be-processed structure.

24. A processing method according to claim 19, wherein an amorphous semiconductor is used as said to-be-processed structure.

25. A processing method according to claim 19, wherein a compound semiconductor is used as said to-be-processed structure.

26. A processing method according to claim 19, further comprising a removal step of removing alcohols and ketones adhering to said to-be-processed structure.

27. A processing method according to claim 26, wherein said removal step removes the adhered alcohols and ketones by using heat and oxygen gas.

28. A processing method according to claim 26, wherein said removal step removes the adhered alcohols and ketones by generating a plasma using an excitation gas species.

29. A processing method according to claim 28, wherein said gas species to be excited for generating the plasma is at least one of argon, krypton, and xenon.

30. A processing method according to claim 28, wherein the adhered alcohols and ketones are removed by using the plasma generated by exciting the gas species with an electromagnetic wave.

31. A processing method according to claim 28, wherein, in said removal step, part of a processing semiconductor device is covered with a semiconductor oxide layer so as not to be exposed to a chemical species excited by the plasma.

32. A processing method according to claim 26, wherein said removal step removes the adhered alcohols and ketones by heating said to-be-processed structure.

33. A processing method, comprising processing a semiconductor device by using the processing liquid according to any of claims 1 to 18, recovering the processing liquid used in a step of processing said semiconductor device, and reusing it after purification.

34. A processing method, further comprising suppressing an oxygen gas concentration of an atmosphere in a processing step of processing a semiconductor device by using the processing liquid according to any of claims 1 to 18.

35. A processing method according to claim 34, wherein a main gas species for suppressing said oxygen gas concentration is nitrogen.

36. A processing method according to claim 34, wherein a main gas species for suppressing said oxygen gas concentration is a mixture of nitrogen and hydrogen.

37. A semiconductor manufacturing apparatus, wherein a semiconductor device is processed by using an aqueous solution adapted to cause a dissolution amount of atoms from a semiconductor to be 15 atomic layers/24 hours or less by conversion.

38. A semiconductor manufacturing apparatus, wherein a semiconductor device is processed by using an aqueous solution containing at least one kind of alcohols and ketones.

39. A semiconductor manufacturing apparatus according to claim 38, wherein said aqueous solution contains at least one kind of the alcohols each having a structure of R1 R2C(OH)R3 (R1 represents one of C1 to C4 alkyl groups having straight and branched chains that may be replaced by halogen and hydroxyl groups. Each of R2 and R3 is the same as or different from R1 1 and represents one of C1 to C4 alkyl groups having straight and branched chains that may be replaced by halogen and hydroxyl groups, or hydrogen atoms.) and the ketones each having a structure of R4C=OR5 (R4 represents one of C1 to C4 alkyl groups having straight and branched chains that may be replaced by halogen and hydroxyl groups. R5 is the same as or different from R4 and represents one of C1 to C4 alkyl groups having straight and branched chains that may be replaced by halogen and hydroxyl groups, or hydrogen atoms.).

40. A semiconductor manufacturing apparatus according to claim 38, wherein said aqueous solution contains at least one kind of compounds in which said alcohols and said ketones have structures comprised of C1 to C7 alkyl groups or alkyl groups containing halogen or heteroatoms.

41. A semiconductor manufacturing apparatus according to claim 38, wherein said aqueous solution contains at least one kind of compounds in which each of said alcohols and said ketones has a relative permittivity of 82 or less.

42. A semiconductor manufacturing apparatus according to claim 38, wherein said one kind of alcohols is 2-propanol.

43. A semiconductor manufacturing apparatus according to claim 38, wherein each of said alcohols and said ketones has a purity of 99 mass% or more and contains metal impurities in total amount of 0.1 ppm or less.

44. A semiconductor manufacturing apparatus according to claim 38, wherein a concentration of said at least one kind of alcohols and ketones is 5 mass% or more.

45. A semiconductor manufacturing apparatus according to any of claims 38 to 44, wherein a semiconductor single crystal or a plane offsetting the semiconductor single crystal is used as said semiconductor device.

46. A semiconductor manufacturing apparatus according to any of claims 38 to 44, wherein a silicon semiconductor is used as said semiconductor device.

47. A semiconductor manufacturing apparatus according to any of claims 38 to 44, wherein a semiconductor polycrystal is used as said semiconductor device.

48. A semiconductor manufacturing apparatus according to any of claims 38 to 44, wherein an amorphous semiconductor is used as said semiconductor device.

49. A semiconductor manufacturing apparatus according to any of claims 38 to 44, wherein a compound semiconductor is used as said semiconductor device.

**50.** A semiconductor manufacturing apparatus according to any of claims 38 to 44, wherein said aqueous solution contains at least one or more of hydrochloric acid, nitric acid, sulfuric acid, acetic acid, hydrofluoric acid, and ammonium fluoride.

**51.** A semiconductor manufacturing apparatus according to any of claims 38 to 44, wherein one or more kinds of nitrogen, hydrogen, oxygen, and ozone are dissolved into water for use in the processing liquid.

**52.** A semiconductor manufacturing apparatus according to any of claims 38 to 44, wherein the adhered alcohols and ketones are removed .

**53.** A semiconductor manufacturing apparatus according to claim 52, wherein the adhered alcohols and ketones are removed by using heat and oxygen gas.

**54.** A semiconductor manufacturing apparatus according to claim 52, wherein the adhered alcohols and ketones are removed by generating a plasma using an excitation gas species.

**55.** A semiconductor manufacturing apparatus according to claim 54, wherein said gas species to be excited for generating the plasma is at least one of argon, krypton, and xenon.

**56.** A semiconductor manufacturing apparatus according to claim 54, wherein the adhered alcohols and ketones are removed by using the plasma generated by exciting the gas species with an electromagnetic wave.

**57.** A semiconductor manufacturing apparatus according to claim 53, wherein said semiconductor device is heated for removing the adhered alcohols and ketones. ,

**58.** A semiconductor manufacturing apparatus according to claim 54, wherein part of said semiconductor device is covered with a semiconductor oxide layer so as not to be exposed to a chemical species excited by the plasma.

**59.** A semiconductor manufacturing apparatus according to any of claims 38 to 44, wherein the processing liquid used in a semiconductor processing step is recovered and reused after purification.

**60.** A semiconductor manufacturing apparatus according to any of claims 38 to 44, wherein an oxygen gas concentration of an atmosphere in a semiconductor processing step is suppressed.

**61.** A semiconductor manufacturing apparatus according to claim 60, wherein nitrogen is used as a main gas species for suppressing the oxygen gas concentration of the atmosphere in the semiconductor processing step.

**62.** A semiconductor manufacturing apparatus according to claim 60, wherein a mixture of nitrogen and hydrogen is used as a main gas species for suppressing the oxygen gas concentration of the atmosphere in the semiconductor processing step.

[FIG. 1]

$$H_2SO_4/H_2O$$

RINSE

DILUTED HF

RINSE

$$NH_4OH/H_2O_2/H_2$$

RINSE

HOT WATER RINSE

RINSE

$$HCl/H_2O_2/H_2O$$

RINSE

DILUTED HF

RINSE

[FIG. 2]

S-1 CLEANING OF SUBSTRATE
S-2 PATTERN FORMATION
S-3 FIELD OXIDATION
S-4 ETCHING
S-5 PREOXIDATION
S-6 ETCHING
S-7 GATE OXIDATION

[FIG. 3]

a)          1

b)          3
            2

c)          4

d)

e)          5

f)

g)          6

[FIG. 4]

S-11 PREOXIDATION
S-12 ETCHING
S-13 ALCOHOL/KETONE
      REMOVAL PROCESS
S-14 GATE OXIDATION

[FIG. 5]

[FIG. 6]

A. MANUFACTURING PROCESS

1. FILM FORMATION ETC.

↓

2. ETCHING ETC.

↓

3. RINSING

↓

4. FILM FORMATION ETC.

B. PURIFICATION PROCESS

5. ADJUSTMENT OF RINSING LIQUID

6. PURIFICATION

[FIG. 7]

[FIG. 8]

[FIG. 9]

[FIG. 10]

## INTERNATIONAL SEARCH REPORT

| | International application No. |
|---|---|
| | PCT/JP2005/012784 |

**A. CLASSIFICATION OF SUBJECT MATTER**
Int.Cl$^7$  H01L21/308, 21/304

According to International Patent Classification (IPC) or to both national classification and IPC

**B. FIELDS SEARCHED**

Minimum documentation searched (classification system followed by classification symbols)
Int.Cl$^7$  H01L21/308, 21/304

Documentation searched other than minimum documentation to the extent that such documents are included in the fields searched
Jitsuyo Shinan Koho        1922-1996    Jitsuyo Shinan Toroku Koho    1996-2005
Kokai Jitsuyo Shinan Koho  1971-2005    Toroku Jitsuyo Shinan Koho    1994-2005

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2000-237705 A  (Ebara Corp.),<br>05 September, 2000 (05.09.00),<br>(Family: none) | 1,37 |
| X<br>Y | JP 2003-115479 A  (Toshiba Corp.),<br>18 April, 2003 (18.04.03),<br>(Family: none) | 2-25,38-51<br>26-36,52-62 |
| Y | JP 2002-282807 A  (Toray Industries, Inc.),<br>02 October, 2002 (02.10.02),<br>(Family: none) | 26-32,52-58 |
| Y | JP 10-116809 A  (Tadahiro OMI),<br>06 May, 1998 (06.05.98),<br>(Family: none) | 33,59 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>26 September, 2005 (26.09.05) | Date of mailing of the international search report<br>11 October, 2005 (11.10.05) |
|---|---|
| Name and mailing address of the ISA/<br>Japanese Patent Office | Authorized officer |
| Facsimile No. | Telephone No. |

Form PCT/ISA/210 (second sheet) (January 2004)

**INTERNATIONAL SEARCH REPORT**

| | International application No. |
|---|---|
| | PCT/JP2005/012784 |

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2003-174006 A (Ebara Corp.),<br>20 June, 2003 (20.06.03),<br>(Family: none) | 34-36,60-62 |

Form PCT/ISA/210 (continuation of second sheet) (January 2004)